Europäisches Patentamt

European Patent Office

Office européen des brevets

(11) Publication number: **0 262 226**
**A1**

(12) **EUROPEAN PATENT APPLICATION**

published in accordance with Art. 158(3) EPC

(21) Application number: 87901124.5

(22) Date of filing: 06.02.87

Data of the international application taken as a basis:

(86) International application number:
PCT/JP87/00076

(87) International publication number:
WO87/04818 (13.08.87 87/18)

(51) Int. Cl.³: **G 06 F 3/023**

(30) Priority: 06.02.86 JP 24449/86

(43) Date of publication of application:
06.04.88 Bulletin 88/14

(84) Designated Contracting States:
DE FR GB

(71) Applicant: **FANUC LTD**
3580, Shibokusa Aza-Komanba Oshino-mura
Minamitsuru-gun Yamanashi 401-05(JP)

(72) Inventor: **TANAKA, Kunio**
5-8-13, Tamakawa-cho Akishima-shi
Tokyo 196(JP)

(72) Inventor: **ONISHI, Yasushi**
Fanuc Hino-syataku 406 3-27, Tamadaira
Hino-shi Tokyo 191(JP)

(72) Inventor: **SATO, Shuuji**
Fanuc Utsugi-Ryo 386-1, Ishikawa-cho
Hachioji-shi Tokyo 192(JP)

(74) Representative: **Billington, Lawrence Emlyn et al,**
HASELTINE LAKE & CO Hazlitt House 28 Southampton
Buildings Chancery Lane
London WC2A 1AT(GB)

(54) **METHOD OF INPUTTING DATA.**

(57) Method of inputting data with different codes through a keyboard (11) to various devices. The kind of key and attribute data inclusive of a destination are stored as attribute table (12) to correspond to a key position (x, y) of each of the keys on the keyboard (11). When the key is depressed, the attribute of the key is read from the attribute table (12) based upon the position (x, y) of the key that is depressed. When the key depressed is a normal key (bearing, for example, an alphabet or a numeral), the operation is carried out to find the data $(Y_i)$ that indicates the kind of a non-normal key that is depressed earlier than said normal key and that is stored in a status register (14) as well as to find an object code table (13(i, j)) that corresponds to a data destination $(Z_i)$ of the normal key. An object code is then read out of a memory region that corresponds to the position (x, y) of the normal key in the object code table, and is transferred to the destination.

EP 0 262 226 A1

./...

Fig.2

<u>DESCRIPTION</u>                    **0262226**

DATA INPUT METHOD

## <u>Technical Field</u>

This invention relates to a data input method and, more particularly, to a data input method through which data is keyed in to a plurality of devices from a single keyboard in the form of respective predetermined codes.

## <u>Background Art</u>

There are systems in which a single keyboard is used for inputting data to a plurality of devices, wherein individual codes which depend upon the respective transfer destinations must be transferred to the devices even if the same alphanumeric key or the like is pressed.

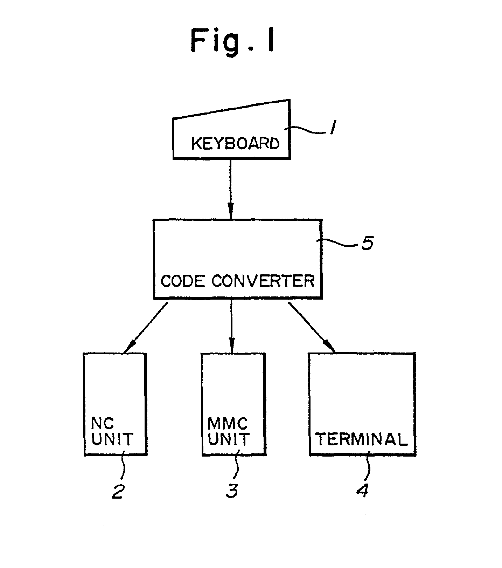

For example, in an NC system, as illustrated in Fig. 1, data inputted from a keyboard 1 must be fed into an NC unit 2 as an ISO or EIA code.  Also, the data must be inputted to an MMC unit (a man-machine controller) 3, which has an automatic programming function and other intelligent functions, in the form of a separate code such as an ASCII code, and to a terminal 4 in the form of yet another code.

Consequently, when the arrangement of the system is decided, the conventional practice is to provide a hardware- or software-type code converter for every device (transfer destination) constituting the system. Then, depending upon the transfer destination and pressed key, the predetermined code is transferred upon being obtained from the particular code converter.

With the conventional system, however, a problem arises in terms of flexibility since the hardware of the code converters and the like must be refabricated whenever the system configuration changes or whenever the system is expanded.

Accordingly, an object of the invention is to provide a data input method in which any modification in a system can be dealt with merely by modifying software, namely the code conversion software.

Disclosure of the Invention

Attribute data which include types of keys and transfer destinations thereof are stored in an attribute table in advance in correspondence with the positions $(x,y)$ of the keys on a keyboard. When a key is pressed, the attributes thereof are read from the attribute table using the position $(x,y)$ of the key pressed. If this key is a normal key (e.g. an alphanumeric key or the like), an object code table is found which conforms to the type of the most recently pressed abnormal key (a shift key or the like) and the data transfer destination on the normal key. An object code is read from a storage area of the object code table that corresponds to the position $(x,y)$ of the normal key, and this object code is trasferred to the transfer destination.

Brief Description of the Drawings

Fig. 1 is an explanatory view of the prior-art method;

Fig. 2 is a schematic explanatory view of the present invention;

Figs. 3 through 5 are views for describing the configuration of attribute data of each key, in which Fig. 3 is an explanatory view of attribute data illustrating key classifications, Fig. 4 is view showing the configuration of normal key attribute data, and Fig. 5 is view showing the configuration of mode key attribute data;

Fig. 6 is a processing flowchart according to the present invention; and

Fig. 7 is a block diagram of a code converter according to the present invention.

Best Mode for Carrying Out the Invention

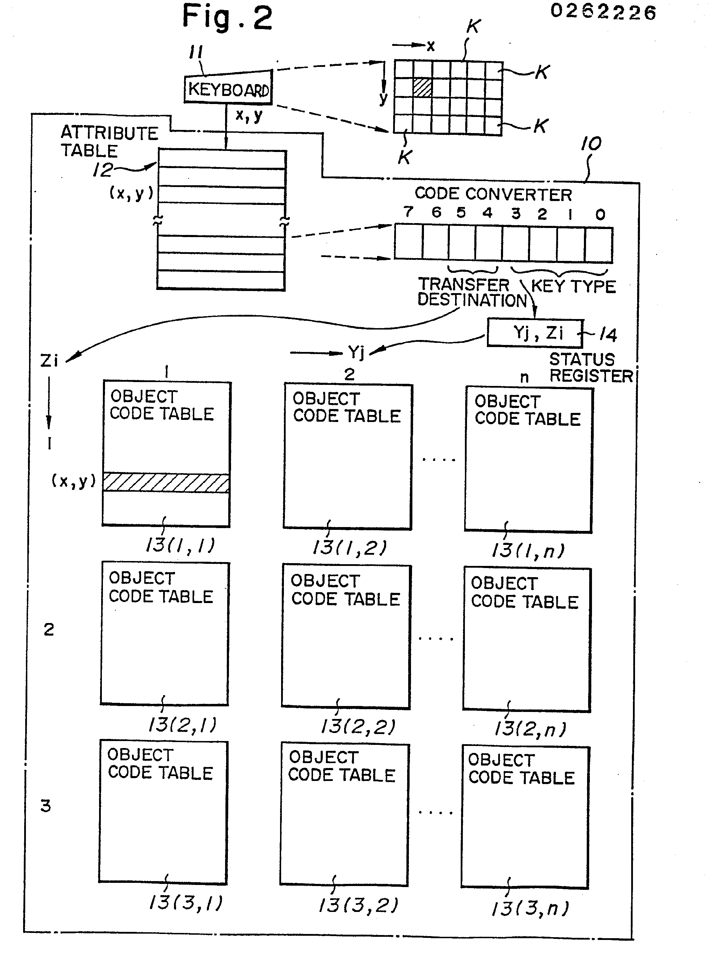

In Fig. 2, numeral 10 denotes a code converter, 11 a keyboard on which keys K are arrayed in a two-dimensional matrix, and 12 an attribute table for storing the correspondence between key position (x,y) and the key attributes. Attributes include key type $Y_j$ and data transfer destination $Z_i$. The keys include normal keys such as alphanumeric keys, and abnormal keys such as a shift key, control (CTRL) key, mode key and alteration (ALT) key. The normal keys include a first normal key for which a data transfer destination is fixed, and a second normal key for which a data transfer destination is not fixed but for which a data transfer destination can be fixed by a mode key (NC key, MMC key, terminal key, etc.). The data transfer destinations are an NC unit, MMC unit and other terminals.

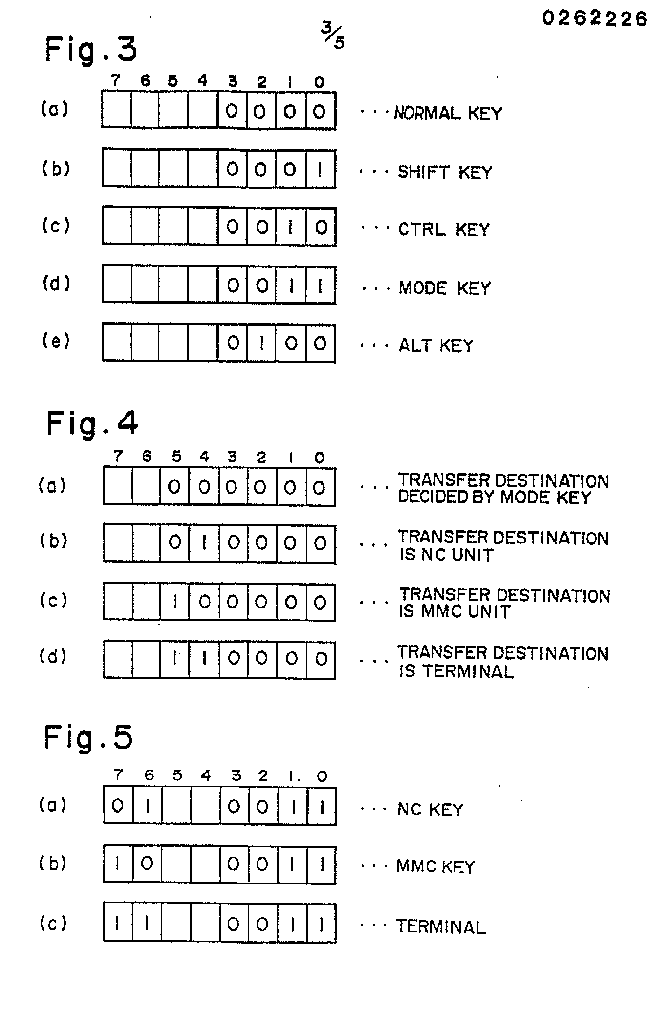

Each storage area of the attribute table 12 is composed of eight bits. Key type is specified by the four lower order bits, the data transfer destination of the first normal key by the next two bits (used solely for the normal key), and the data transfer destination of the second normal key by the two most significant bits (used solely for the mode key). More specifically, as shown in Figs. 3(a) - (e), "0000" is stored in the four lower order bits if the key type is normal,"0001" if the type of key is the shift key, "0010" for the CTRL key, "0011" for the mode key, and "0100" for the ALT key. Further, "00" is stored in the nex two higher order bits [Fig. 4(a)] if the transfer destination of the normal key is decided by the mode key , "01" [Fig. 4(b)] if the transfer destination is the NC unit, "10" [Fig. 4(c)] if the transfer destination is the MMC unit, and "11" [Fig. 4(d)] if the transfer destination is a terminal. Also, as shown in Figs. 5(a) - (c), "01" is stored in the two most significant bits if the mode key is the NC key, "10" if the mode key is the MMC key, and "11" if the mode key is the terminal key.

Returning to Fig. 2, there are shown at numerals 13(i,j) (i = 1, 2, ..., j = 1, 2, ...) object code

tables provided to correspond to key types and their data transfer destinations and storing object codes corresponding to the array positions (x,y) of the respective normal keys pressed. It should be noted that an object code is a code transferred to the destination of the party concerned. Numeral 14 denotes a status register for storing the data $Y_j$ indicative of key type and the data transfer destination $Z_i$ (only in case of a mode key) included in the attribute data of the abnormal keys.

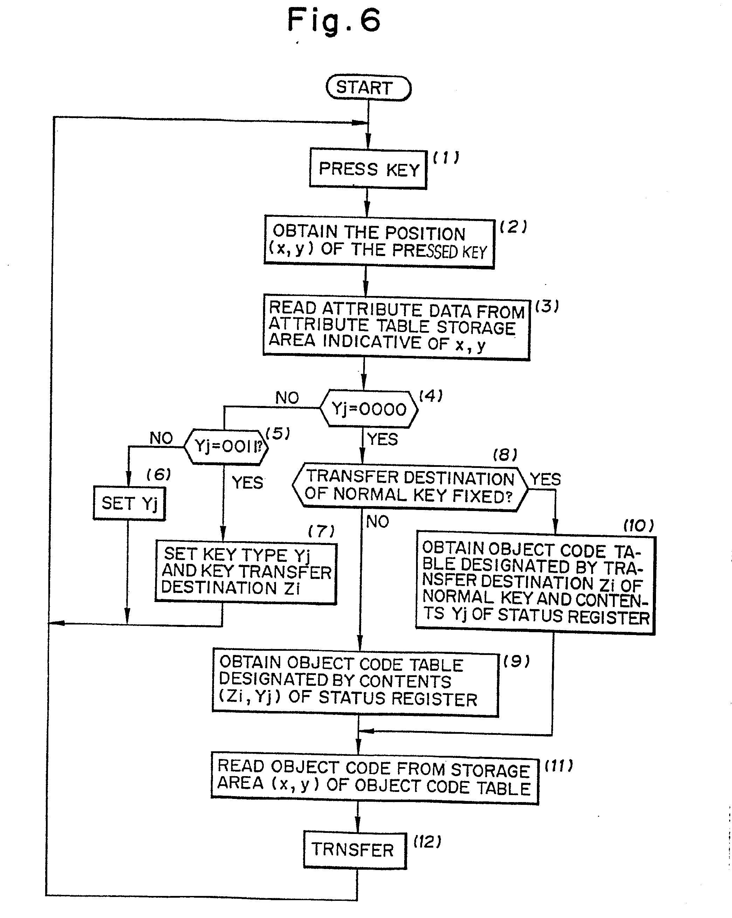

Fig. 6 is a processing flowchart according to the invention and will now be described in accordance with Figs. 1 through 6.

(1) First, a predetermined key on the keyboard 11 is pressed.

(2) When the key is pressed, a processor (not shown) in the code converter 10 finds the physical array position (x,y) of the key pressed.

(3) Thereafter, the attributes of this key are read from the attribute table using the physical array position (x,y).

(4) The processor checks to determine whether the contents $Y_j$ (key type) of the four lower order bits of the attribute data are "0000", or in other words, the pressed key is a normal key or not.

(5) If the key is not a normal key (i.e. if the key is an abnormal key), then it is determined whether $Y_j = 0011$ holds, namely whether the pressed key is a mode key.

(6) If the key is not a mode key, then the data $Y_j$ indictive of the key type is stored in the status register 14 and pressing of the next normal key is awaited.

(7) If the key is a mode key, on the other hand, then the data (0011) of the four lower order bits indicating the type of key is stored in the status register 14 as $Y_j$ and the data in the two most significant bits is stored in the status register 14 as the data destination $Z_i$ of the second normal key. Pressing of the next normal key is then awaited.

(8) If $Y_j = 0000$ holds at step (4), or in other words, if the pressed key is a normal key, it is determined whether the normal key is the first key for which the data transfer destination is fixed. Whether or not the normal key is the first key is determined by checking whether the fourth and fifth bits of the attribute data are "00" (see Fig. 4).

(9) If the data transfer destination of the pressed normal key is not fixed (i.e. if the normal key is the second normal key), then the system finds the object code table designated by $Y_j$ and the data transfer destination $Z_i$, which were stored in the status register 14 at step (7).

(10) On the other hand, if the data transfer destination of the pressed normal key has been fixed (i.e. if the normal key is the first normal key), then the system finds the object code table 13(i,j) corresponding to $Y_j$, which indicates the type of the abnormal key pressed before the abovementioned normal key was pressed, and which was stored in the status register 14 at step (60, and the data transfer destination $Z_i$ contained in the attribute data of the normal key. It should be noted that the object code table 13(i,j) is that at row $Z_i$, column $Y_j$ in Fig. 2.

(11) When the object code table has been obtained, the processor reads out an object code from a storage area of object code table 13(i,j) that corresponds to the array position (x,y) of the pressed normal key.

(12) The read object code is then transferred to the prescribed transfer destination. Thereafter, the processing from step (1) onward is repeated whenever a key is pressed.

Accordingly, if the key type of the most recently pressed abnormal key is "0001" ($Y_j = 1$) and a normal key which has been pressed is the first normal key for which the transfer destination is the NC unit "01" ($Z_i = 1$), by way of example, then an object code is read from the normal key position (x,y) of the object code table 13(1,1). Thus, which code is outputted is decided by the abnormal key (i.e. decided by $Y_j$), and the transfer destination is decided by the normal key (i.e. decided by $Z_i$).

If the most recently pressed abnormal key is a mode key (e.g. the NC key), then, as shown in Fig. 5(a), the four lower order bits will be "0011" ($Y_j = 3$) and the two most significant bits will be "01" ($Z_i = 1$). Therefore, if the normal key pressed after the NC key is the second normal key, an object code will be read from the normal key position (x,y) of the object code table 13(3,1) and this object code will be transferred to the NC unit.

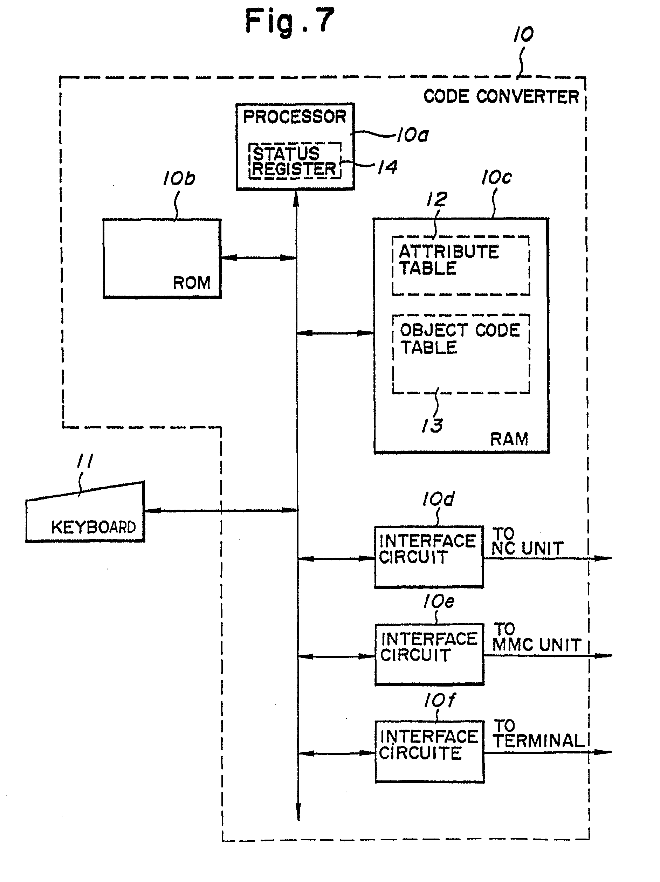

Fig. 7 is a block diagram of the code converter 10 shown in Fig. 1; portions similar to those shown in Fig. 1 are designated by like reference characters.

In the code converter 10, numeral 10a denotes a processor which includes the status register 14, 10b a ROM storing a control program, 10c a RAM for storing the attribute table 12 and object code table 13, 10d an interface circuit for interfacing the NC unit, 10e an interface circuit for interfacing the MMC unit, and 10f an interface circuit for interfacing the terminal.

Thus, in accordance with the present invention, an attribute table for storing key attributes and a plurality of object code tables are provided. The arrangement is such that an object code table is obtained that conforms to the type of an abnormal key pressed before a normal key and the data transfer destination of the normal key pressed thereafter, an object code is read from a storage area of the object code table that corresponds to the array position of the normal key, and this object code is transferred to '

0262226

the transfer destination. Therefore, the data transfer destinations and codes can be altered in any way whatsoever by changing the attribute table and object code tables. Accordingly, if there is to be such an alteration, this can be readily dealt with merely by altering the attribute table and object code tables in the code software.

CLAIMS:

1.   A data input method characterized by:

providing an attribute table storing correspondence between array positions of keys on a keyboard and attributes of said keys, and object code tables each provided in accordance with a key type and data transfer destination thereof and storing object codes corresponding to  the array positions of the keys;

including at least a key type and data transfer destination thereof as an attribute of a normal key among said keys, and including at least a key type as an attribute of an abnormal key among said keys;

obtaining from the attribute table an attribute conforming to a pressed key and, if said pressed key is a normal key on the basis of the attribute data, obtaining an object code table conforming to the type of a most recently pressed key among the abnormal keys and the data transfer destination of said pressed normal key; and

reading an object code from a storage area of said object code table that corresponds to the array position of said normal key, and transferring the object code to a transfer destination.

2.   A data input method according to claim 1, characterized in that if a pressed key is an abnormal key, data indicative of the type of the key are stored.

3.   A data input method according to claim 2, characterized in that normal keys include alphanumeric keys, and abnormal keys include a shift key, a control key, an alteration key and a mode key.

4.  A data input method characterized by:

providing an attribute table storing correspondence between array positions of keys on a keyboard and attributes of said keys, and object code tables each provided in accordance with a key type and data transfer destination thereof and storing object end codes corresponding to the array positions of the keys;

providing as a normal key among said keys a first normal key for which a data transfer destination is fixed and a second normal key for which a data transfer destination is not fixed, and providing abnormal keys with mode keys for designating a data transfer destinations of the second normal key;

if the first normal key is pressed, obtaining an object code table conforming to the type of an abnormal key pressed last before said normal key was pressed, and if the second normal key is pressed, obtaining an object code table conforming to the type and data transfer destination of a mode key pressed before said normal key was pressed; and

reading an object code from a storage area of said object code table that corresponds to the array position of said normal key, and transferring the object code to a transfer destination.

0262226

5.   A data input method according to claim 4, characterized in that if a pressed key is an abnormal key other than a mode key, data indicative of the type of the key are stored, and if the pressed key is a mode key, the type of the key and the data transfer destination thereof are stored.

# Fig. 1

KEYBOARD — 1

CODE CONVERTER — 5

NC UNIT — 2

MMC UNIT — 3

TERMINAL — 4

# Fig. 2

KEYBOARD

x, y

K

K

K

K

ATTRIBUTE TABLE

12

(x,y)

CODE CONVERTER

7 6 5 4 3 2 1 0

TRANSFER DESTINATION

KEY TYPE

Yj, Zi

14

STATUS REGISTER

10

Zi

Yj

1

2

n

OBJECT CODE TABLE

(x,y)

13(1,1)

OBJECT CODE TABLE

13(1,2)

OBJECT CODE TABLE

. . . .

13(1,n)

OBJECT CODE TABLE

13(2,1)

OBJECT CODE TABLE

13(2,2)

OBJECT CODE TABLE

. . . .

13(2,n)

2

OBJECT CODE TABLE

13(3,1)

OBJECT CODE TABLE

13(3,2)

OBJECT CODE TABLE

. . . .

13(3,n)

3

# Fig.3

| | 7 | 6 | 5 | 4 | 3 | 2 | 1 | 0 | |
|---|---|---|---|---|---|---|---|---|---|
| (a) | | | | | 0 | 0 | 0 | 0 | · · · NORMAL KEY |
| (b) | | | | | 0 | 0 | 0 | 1 | · · · SHIFT KEY |
| (c) | | | | | 0 | 0 | 1 | 0 | · · · CTRL KEY |
| (d) | | | | | 0 | 0 | 1 | 1 | · · · MODE KEY |
| (e) | | | | | 0 | 1 | 0 | 0 | · · · ALT KEY |

# Fig.4

| | 7 | 6 | 5 | 4 | 3 | 2 | 1 | 0 | |
|---|---|---|---|---|---|---|---|---|---|
| (a) | | | 0 | 0 | 0 | 0 | 0 | 0 | · · · TRANSFER DESTINATION DECIDED BY MODE KEY |
| (b) | | | 0 | 1 | 0 | 0 | 0 | 0 | · · · TRANSFER DESTINATION IS NC UNIT |
| (c) | | | 1 | 0 | 0 | 0 | 0 | 0 | · · · TRANSFER DESTINATION IS MMC UNIT |
| (d) | | | 1 | 1 | 0 | 0 | 0 | 0 | · · · TRANSFER DESTINATION IS TERMINAL |

# Fig.5

| | 7 | 6 | 5 | 4 | 3 | 2 | 1 | 0 | |
|---|---|---|---|---|---|---|---|---|---|
| (a) | 0 | 1 | | | 0 | 0 | 1 | 1 | · · · NC KEY |
| (b) | 1 | 0 | | | 0 | 0 | 1 | 1 | · · · MMC KEY |
| (c) | 1 | 1 | | | 0 | 0 | 1 | 1 | · · · TERMINAL |

# Fig. 6

START

(1) PRESS KEY

(2) OBTAIN THE POSITION (x, y) OF THE PRESSED KEY

(3) READ ATTRIBUTE DATA FROM ATTRIBUTE TABLE STORAGE AREA INDICATIVE OF x, y

(4) $Y_j = 0000$

NO → (5) $Y_j = 0011$?

NO → (6) SET $Y_j$

YES → (7) SET KEY TYPE $Y_j$ AND KEY TRANSFER DESTINATION $Z_i$

YES → (8) TRANSFER DESTINATION OF NORMAL KEY FIXED?

YES → (10) OBTAIN OBJECT CODE TABLE DESIGNATED BY TRANSFER DESTINATION $Z_i$ OF NORMAL KEY AND CONTENTS $Y_j$ OF STATUS REGISTER

NO → (9) OBTAIN OBJECT CODE TABLE DESIGNATED BY CONTENTS $(Z_i, Y_j)$ OF STATUS REGISTER

(11) READ OBJECT CODE FROM STORAGE AREA (x, y) OF OBJECT CODE TABLE

(12) TRNSFER

0262226

# Fig.7

CODE CONVERTER *10*

PROCESSOR *10a*

STATUS REGISTER *14*

*10b*

ROM

*12*   *10c*

ATTRIBUTE TABLE

OBJECT CODE TABLE

*13*

RAM

*11*

KEYBOARD

*10d*

INTERFACE CIRCUIT → TO NC UNIT

*10e*

INTERFACE CIRCUIT → TO MMC UNIT

*10f*

INTERFACE CIRCUITE → TO TERMINAL

## I. CLASSIFICATION OF SUBJECT MATTER (if several classification symbols apply, indicate all) ³

According to International Patent Classification (IPC) or to both National Classification and IPC

Int.Cl⁴    G06F3/023

## II. FIELDS SEARCHED

| Minimum Documentation Searched ⁴ | |
|---|---|
| Classification System | Classification Symbols |
| IPC | G06F3/023 |

Documentation Searched other than Minimum Documentation
to the Extent that such Documents are Included in the Fields Searched ⁵

Jitsuyo Shinan Koho    1971 – 1987

## III. DOCUMENTS CONSIDERED TO BE RELEVANT ¹⁴

| Category* | Citation of Document, ¹⁶ with indication, where appropriate, of the relevant passages ¹⁷ | Relevant to Claim No. ¹⁸ |
|---|---|---|
| X | JP, A, 60-48534 (Hitachi, Ltd.) 16 March 1985 (16. 03. 85) (Family: none) | 1-4 |
| X | JP, A, 61-25234 (Ricoh Co., Ltd.) 4 February 1986 (04. 02. 86) (Family: none) | 1-4 |
| P | JP, A, 61-259323 (Dainippon Printing Co., Ltd.) 17 November 1986 (17. 11. 86) (Family: none) | 1-4 |
| X | JP, A, 56-90331 (Toshiba Corp.) 22 July 1981 (22. 07. 81) (Family: none) | 1-4 |
| X | JP, A, 58-195926 (Fujitsu Ltd.) 15 November 1983 (15. 11. 83) (Family: none) | 1-4 |

* Special categories of cited documents: ¹⁵

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search ² | Date of Mailing of this International Search Report ² |
|---|---|
| May 1, 1987 (01. 05. 87) | May 18, 1987 (18. 05. 87) |
| International Searching Authority ¹ | Signature of Authorized Officer ²⁰ |
| Japanese Patent Office | |

Form PCT/ISA/210 (second sheet) (October 1981)